# EUROPEAN PATENT APPLICATION

(11) **EP 3 675 614 A1**
(43) Date of publication of application: **01.07.2020**
(21) Application number: 19194636.7
(22) Date of filing: 30.08.2019
(51) Int. Cl.: H05K 7/20

(54) **DYNAMIC AIR IMPEDANCE MECHANISM IN SERVER DUCTING**

(30) Priority: 26.12.2018 US 201862785098 P; 15.05.2019 US 201916413238
(71) Applicant: Quanta Computer Inc., Taoyuan City 33377 (TW)
(72) Inventor: CHEN, Chao-Jung, 33377 Taoyuan City (TW); HUANG, Yu-Nien, 33377 Taoyuan City (TW); CHEN, Ching-Yu, 33377 Taoyuan City (TW); LI, Tsung-Ta, 33377 Taoyuan City (TW)
(74) Representative: dompatent von Kreisler Selting Werner - Partnerschaft von Patent- und Rechtsanwälten mbB

(57) **Abstract**

A dynamic air impedance mechanism is provided which has particular utility in changing the impedance of air flow within servers. The mechanism comprises an air duct having a plurality of vent holes, a control plate defining a plurality of openings, and a fan to draw air through the vent holes in the air duct. Relative movement between the openings in the control plate and the corresponding vent holes in the air duct changes the impedance.

## Description

### FIELD OF THE INVENTION

This disclosure relates to a mechanism for dynamic air impedance in server ducting, and to a method of controlling air flow in servers.

### BACKGROUND

Current server systems use air duct(s) for air flow management of cooling air. The air duct(s) are provided with venting hole(s) to manage impedance, while the cooling air flows through the air duct. In the same air flow rate condition, the impedance of the air duct is a constant due to the fact that dimension(s), quantity of air flow, and location of venting hole(s) on the air duct are fixed. "Impedance" is an obstruction to movement, in this case, an obstruction in the flow of air. As the flow of air slows down due to the impedance, a pressure gradient is formed upstream of the obstacle.

However, there is not currently a mechanism or method to dynamically change the dimension(s) and quantity of venting hole(s) to adjust impedance in the same air duct for different system configuration requirements and fan power savings.

### SUMMARY

In one embodiment, the present disclosure provides a dynamic air impedance mechanism, including a control plate and an air duct with venting hole(s), wherein the control plate and the air duct with venting hole(s) are relatively moveable in order to change the air impedance.

In another embodiment, the present disclosure provides a system in which the configuration of air flow through a server can be dynamically altered to meet the requirements of cooling the system when server components are altered, rearranged, or substituted on the chassis of the server.

In still a further embodiment, power savings associated with cooling fan(s) is realized by utilizing the dynamic air impedance mechanism to adjust the impedance of the server based on the cooling requirements of the components of the server.

In a further embodiment of the disclosure, each of several of multiple air ducts bringing cooling air to different components on a server chassis can be provided with the dynamic air impedance mechanism of the disclosure.

One disclosed embodiment is a dynamic air flow impedance mechanism. The mechanism includes an air duct that contains a plurality of vent holes, a control plate that contains a plurality of openings, and a fan. The air duct and the control plate are arranged in relative motion to each other. A fan draws air through the vent holes in the air duct. By moving the plurality of openings in the control plate relative to the plurality of vent holes in the air duct, impedance of airflow through the plurality of vent holes is adjusted.

In a second embodiment, a server comprises a chassis,a plurality of different electronic components, at least one cooling fan; and at least one air duct having a plurality of vent holes. The server also includes at least one control plate with a plurality of openings. The plurality of openings in the at least one control plate is relatively moveable in relation to the plurality of vent holes in the at least one duct. The relative movement results in the adjustment of impedance of an air flow through the at least one air duct.

A third embodiment discloses a method of adjusting the impedance of air flow through a server having a plurality of electronic components that are arranged to be cooled by an air duct. At least one air duct brings air through a plurality of vent holes in the air duct. At least one fan draws air through the air duct. A control plate defines a plurality of openings. The control plate is provided with relative movement with regard to the corresponding vent holes in the air duct. As a result, the relative movement of the openings in the control plate and the corresponding vent holes in the air duct control the impedance of the server.

The above summary is not intended to represent each embodiment or every aspect of the present disclosure. Rather, the foregoing summary merely provides an example of some of the novel aspects and features set forth herein. The above features and advantages, and other features of the present disclosure, will be readily apparent from the following detailed description of representative embodiments and modes for carrying out the present invention, when taken in conjunction with the accompanying drawings and appended claims.

### BRIEF DESCRIPTION OF THE DRAWINGS

In order to describe the manner in which the above-recited disclosure and its advantages and features can be obtained, a more particular description of the principles briefly described above will be rendered by reference to specific examples that are illustrated in the appended drawings. The drawings depict only exemplary embodiments, and are therefore not to be considered as limitations on the of the various embodiments or the claims. The principles herein are described and explained with additional specificity and detail through the use of the accompanying drawings.
FIG. 1A is a schematic representation of a low-impedance mode requirement of a server.
FIG. 1B is a schematic representation of a high impedance mode requirement of a server of different configuration than the server of FIG. 1A.
FIG. 2 is a schematic, exploded view of the dynamic air impedance mechanism of the present disclosure.
FIG. 3A is a schematic representation of the control plateof the disclosure in a first configuration.
FIG. 3B is a schematic representation of FIG. 3A but in a second configuration.
FIG. 4 is a graphic representation of the relation of impedance and air flow.
FIG. 5 is a graphic representation of one relationship between fan pressure, impedance and air flow.

### DETAILED DESCRIPTION

The various embodiments is/are described with reference to the attached figures, wherein like reference numerals are used throughout the figures to designate similar or equivalent elements. The figures are not drawn to scale and are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details, or with other methods. In other instances, well-known structures or operations are not shown in detail to avoid obscuring the invention. The various embodiments is/are not limited by the illustrated ordering of acts or events, as some acts may occur in different orders and/or concurrently with other acts or events. Furthermore, not all illustrated acts or events are required to implement a methodology in accordance with the present invention.

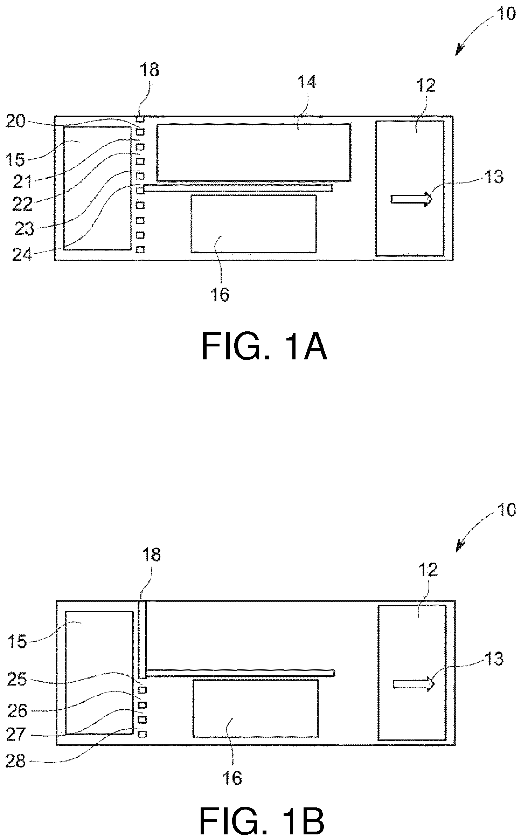

FIG. 1A illustrates a chassis 10 having various electronic components of a server arranged on and within the chassis 10. The various electronic components within the chassis have different cooling requirements, depending on the nature, number, and arrangement of the electronic components on and within chassis 10. A fan 12 draws air in the direction of arrow 13 through the chassis 10 in order to cool various electronic components, such as a PCIe card 14and a CPU 16, by drawing air through an air duct 18 having a plurality of vent holes 20, 21, 22, 23, 24, etc. As shown in FIG. 1A, the air duct 18 is operating in a low impedance mode. While we have illustrated only a single fan 12, it should be understood that more than one fan 12 can be provided to draw the air through the chassis 10. In fact, more than one air duct 18 can be provided within a single chassis 10, in order to specifically provide cooling air to certain of, or a group of, components that have cooling requirements different than other electronic components within chassis 10. Fan 12 is conventionally an electrical motor powered fan, but other forms of power can be used to power fan 12, such as hydraulic power. Other components, such as hard disc drive ("HDD") 15 can also be housed within chassis 10.

Contrast the low impedance mode of FIG. 1A with the high impedance mode illustrated in FIG. 1B. FIG. 1B illustrates the same chassis 10 as in FIG. 1A but having a different arrangement of components therein. The fan 12 still draws air in the direction of arrow 13. The CPU 16 is still arranged between the air duct 18 and the fan 12. However, a PCIe card is omitted from the configuration of FIG. 1B. Thus, the vent holes 20, 21, 22, 23, 24 in FIG. 1A are now closed by the dynamic air impedance mechanism of the disclosure, leaving only vent holes 25, 26, 27, 28 open to allow air to flow through air duct 18.

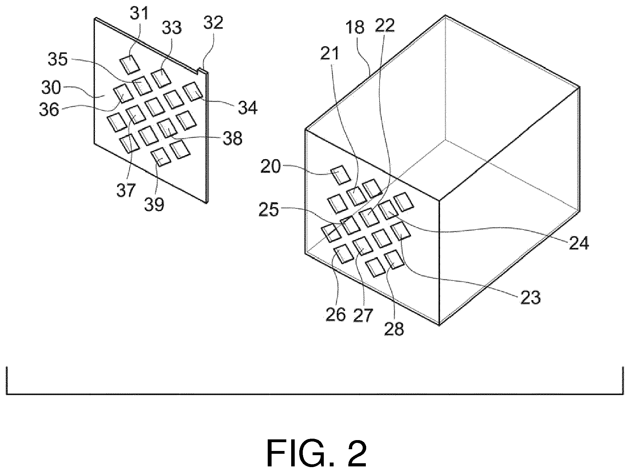

FIG. 2 is an exploded view of one embodiment of dynamic air impedance mechanism according to the present disclosure. Air duct 18 is provided with a plurality of vent holes 20, 21, 22, 23, 24, 25, 26, 27, 28. While we have illustrated the individual vent holes 20, 21, 22, 23, 24, 25, 26, 27, and 28 as having a square or diamond shape of the same size, it is to be expressly understood that such is only an example of the shape, size and distribution of the vent holes. The vent holes may be of dissimilar shape and/or dimensions. For example, some may be quadrilateral in shape but some may have sides of the same dimension and some may have sides of different dimensions. Included within such shapes are squares, rectangles, parallelogram, rhombus, trapezoids and kite. Alternatively, the vent holes may be defined by a number of sides other than four, such as triangles, pentagons, hexagon, heptagons, and octagons, et. The vent holes may also be of curved configuration, including circular, elliptical, arched, lens, crescent, oval, quatrefoil, and other curved shapes.

FIG. 2 also illustrates control plate 30, which is arranged with the air duct 18 so as to be relatively moveable in relation thereto. Control plate 30 can be provided with a tab 32, by which pressure can be applied to control plate 30 to assist in relative movement with air duct 18. Control plate 30 is also provided with a plurality of openings 31, 33, 34, 35, 36, 37, 38, 39, etc., therein. Again, while these openings 31, 33, 34, 35, 36, 37, 38, 39, etc., in the control plate 30 have been exemplified as square or diamond shaped, they may take on the same or different configurations suitable for vent holes 20, 21, 22, 23, 24, 25, 26, 27 and 28.

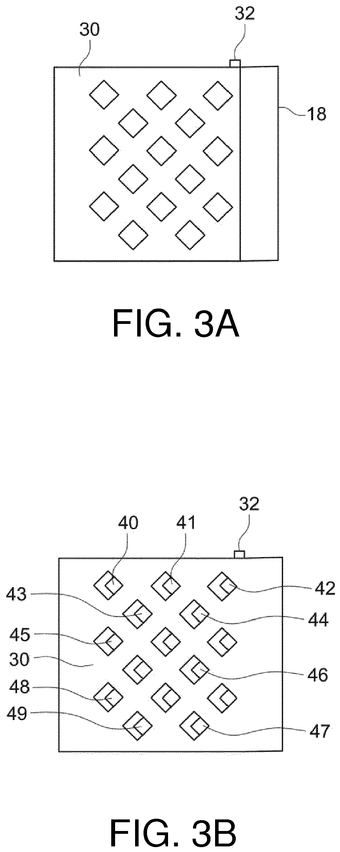

As can be seen in FIG. 3A, when the openings in control plate 30 are aligned with the vent holes in the air duct 18, the maximum (low impedance) flow of air will be drawn into the air duct 18.

However, by relatively moving air duct 18 and control plate 30 as shown in FIG. 3B, the resulting openings 40, 41, 42, 43, 44, 45, 46, 47, 48, and 49, etc., will be diminished in size as compared to either vent holes 20, 21, 22, 23, 24, 25, 26, 27, 28, etc., in the air duct 18, and openings 31, 33, 34, 35, 36, 37, 38, 39, etc., in control plate 30. FIG. 3B will have higher impedance that the configuration of FIG. 3A.

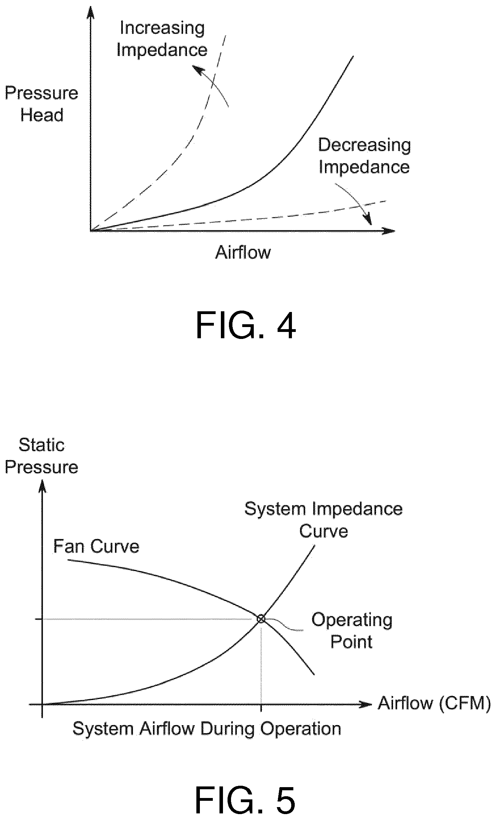

The relationship between impedance and air flow is shown diagrammatically in FIG. 4. Generally, as impedance increases, the required pressure head (and corresponding power consumed by the fan) increases. By decreasing impedance, air flow also increases, while reducing the power consumption of the fan.

FIG. 5 illustrates a desired operating point, where the fan curve, system impedance, and system airflow during operation all intersect. While the system can be operated outside this point of intersection, the present dynamic air impedance mechanism of this disclosure provides a simple manner of controlling the amount of impedance to permit the attainment of desired balance of airflow and power consumption of the fan.

While various embodiments of the present invention have been described above, it should be understood that they have been presented by way of example only, and not limitation. Numerous changes to the disclosed embodiments can be made in accordance with the disclosure herein, without departing from the spirit or scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur or be known to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

The terminology used herein is for the purpose of describing particular embodiments only, and is not intended to be limiting of the invention. As used herein, the singular forms "a," "an," and "the" are intended to include the plural forms as well, unless the context clearly indicates otherwise. Furthermore, to the extent that the terms "including," "includes," "having," "has," "with," or variants thereof, are used in either the detailed description and/or the claims, such terms are intended to be inclusive in a manner similar to the term "comprising."

Unless otherwise defined, all terms (including technical and scientific terms) used herein have the same meaning as commonly understood by one of ordinary skill in the art. Furthermore, terms, such as those defined in commonly used dictionaries, should be interpreted as having a meaning that is consistent with their meaning in the context of the relevant art, and will not be interpreted in an idealized or overly formal sense unless expressly so defined herein.

## Claims

1. A dynamic air flow impedance mechanism, **characterized in that** comprising:
an air duct (18) having a plurality of vent holes (20, 21, 22, 23, 24, 25, 26, 27, 28) therein;
a control plate (30) having a plurality of openings (31, 33, 34, 35, 36, 37, 38, 39) therein; the air duct (18) and the control plate (30) being arranged in relative motion to each other; and
a fan (12) to draw air through the vent holes (20, 21, 22, 23, 24, 25, 26, 27, 28) in the air duct (18),
wherein, by moving the plurality of openings (31, 33, 34, 35, 36, 37, 38, 39) in the control plate (30) relative to the plurality of vent holes (20, 21, 22, 23, 24, 25, 26, 27, 28) in the air duct (18), impedance of an airflow through the plurality of vent holes (20, 21, 22, 23, 24, 25, 26, 27, 28) is adjusted.

2. The dynamic air flow impedance mechanism of claim 1, wherein each of the plurality of openings in the control plate is of quadrilateral shape.

3. The dynamic air flow impedance mechanism of claim 2, wherein each of the plurality of vent holes is of the same shape as a corresponding opening of the plurality of openings in the control plate.

4. The dynamic air flow impedance mechanism of claim 2, wherein each of the plurality of vent holes is of a different shape than a corresponding opening of the plurality of openings in the control plate.

5. The dynamic air flow impedance mechanism of claim 2, wherein each of the plurality of vent holes is of curvilinear shape.

6. The dynamic air flow impedance mechanism of claim 1, wherein the airflow through the plurality of vent holes is regulated by controlling the position of the plurality of openings in the control plate, relative to the position of the plurality of vent holes in the air duct.

7. A server comprising a chassis and a plurality of different electronic components, the server includes at least one cooling fan, at least one air duct, and at least one air duct having a plurality of vent holes therein; and at least one control plate defining a plurality of openings therein; wherein the plurality of openings in the at least one control plate are relatively moveable, in relation to the plurality of vent holes in the at least one duct, the relative movement resulting in adjustment of air impedance through the at least one air duct.

8. The server of claim 7, wherein the number of the at least one air duct is one, and the number of the at least one control plate is one.

9. The server of claim 7, wherein each of the plurality of openings in the control plate is of quadrilateral shape.

10. The server of claim 9, wherein each of the plurality of vent holes in the duct is of quadrilateral shape.

11. The server of claim 9, wherein each of the plurality of vent holes in the duct is of shape different than the shape of a corresponding opening of the plurality of openings in the control plate.

12. The server of claim 7, wherein each of the plurality of openings in the control plate differs in at least one of shape and size from at least one of the shape and size of a corresponding vent hole of the plurality of vent holes.

13. A method of adjusting the impedance of air flow through a server having a plurality of electronic components arranged therein to be cooled by an air duct, **characterized in that** comprising:
providing at least one air duct (18) to bring air through a plurality of vent holes (20, 21, 22, 23, 24, 25, 26, 27, 28) in the air duct (18);
providing at least one fan (12) to draw air through the air duct (18);
providing a control plate (30) defining a plurality of openings (31, 33, 34, 35, 36, 37, 38, 39) therein, the control plate (30) being provided with relative movement with regard to the corresponding vent holes (20, 21, 22, 23, 24, 25, 26, 27, 28) in the air duct (18), such that relative movement of the openings (31, 33, 34, 35, 36, 37, 38, 39) in the control plate (30) and the corresponding vent holes (20, 21, 22, 23, 24, 25, 26, 27, 28) in the air duct (18) control the impedance of the server.

14. The method of claim 13, wherein the impedance of the air flow is adjusted to maximize air flow over the electronic components.

15. The method of claim 13, wherein the impedance of the air flow is adjusted to reduce the power consumption of the fan.
